# EUROPEAN PATENT APPLICATION

(11) **EP 1 959 100 A2**
(43) Date of publication of application: **20.08.2008**
(21) Application number: 08002661.0
(22) Date of filing: 13.02.2008
(51) Int. Cl.: F01D 5/28, C23C 28/00

(54) **Heat resistant member**

(30) Priority: 16.02.2007 JP 2007035670
(71) Applicant: KABUSHIKI KAISHA TOSHIBA, Tokyo (JP)
(72) Inventor: Ishiwata, Yutaka, Minato-ku Tokyo (JP); Matsumoto, Kazuhide, Minato-ku Tokyo (JP); Ito, Yoshiyasu, Minato-ku Tokyo (JP)
(74) Representative: Kramer - Barske - Schmidtchen

(57) **Abstract**

A heat resistant member includes a metal or ceramic substrate and a thermal-barrier coating layer disposed on the substrate. The thermal-barrier coating layer includes a metal layer functioning as a bonding layer and one or more ceramic layers disposed on the metal layer. At least one of the ceramic layers is mainly composed of a hafnium oxide-based ceramic layer containing 85% or more of hafnium oxide. Due to the above structure, there can be provided a heat resistant member with high heat resistance and durability which has a thermal-barrier coating layer with stable thermal conductivity at elevated temperatures, namely, not less than 1,200°C, and resistance to cracking and delamination due to sintering.

## Description

### BACKGROUND OF THE INVENTION

### 1. Field of the Invention

The present invention relates to heat-resistant members, used for gas turbines and jet engines, for example, to be exposed to a high-temperature combustion gas, and particularly to a heat resistant member having a predetermined thermal barrier coating layer formed on a surface of a substrate to increase heat resistance and durability.

### 2. Description of the Related Art

Components of gas turbines and jet engines, including rotor blades, stator blades, and combustors, are exposed to a high-temperature combustion gas above 1,000°C. Such members are typically formed of a heat-resistant alloy called nickel-based superalloy. Because its strength decreases sharply above 1,000°C, the front and back surfaces of the members are maintained at about 900°C by a cooling system using a coolant such as water, air, or steam. There has been a trend, however, toward higher combustion gas temperatures to boost combustion efficiency and power generating efficiency; recent gas turbines and jet engines have been operated at a combustion gas temperature of 1,300°C, or as high as 1,500°C. The conventional cooling system is therefore insufficient to maintain the members at 900°C or less.

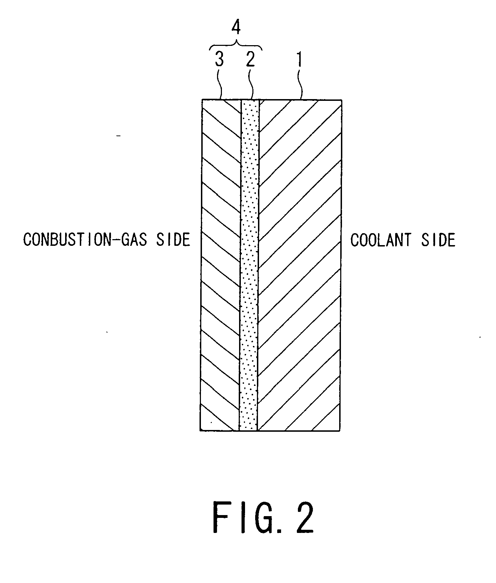

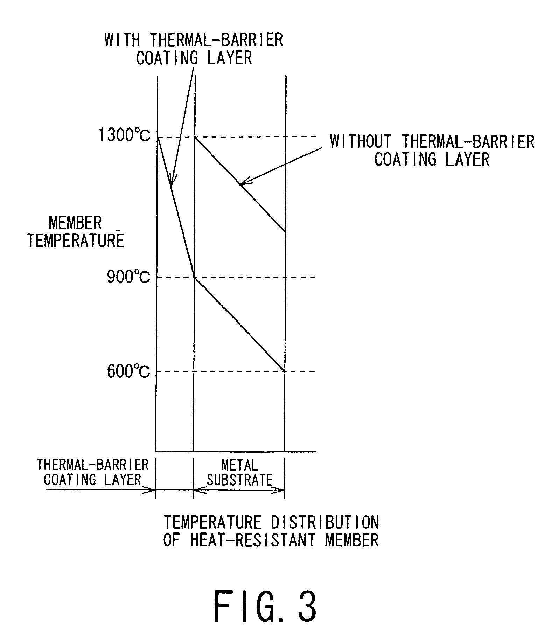

Referring to Figs. 2 and 3, a latest gas turbine or jet engine includes a member (metal substrate) 1 having a ceramic thermal-barrier coating layer 4 with low thermal conductivity and superior thermal barrier properties (heat shielding properties). The thermal-barrier coating layer 4 can form a large temperature gradient to suppress an increase in the temperature of the metal substrate 1 with increasing combustion gas temperature. Preferably, the thermal-barrier coating layer 4 is formed of a ceramic material with low thermal conductivity and high heat resistance; typically, yttrium oxide-stabilized zirconium oxide (ZrO₂·Y₂O₃) has been widely used (for example, see Japanese Unexamined Patent Application Publication No. 8-246901).

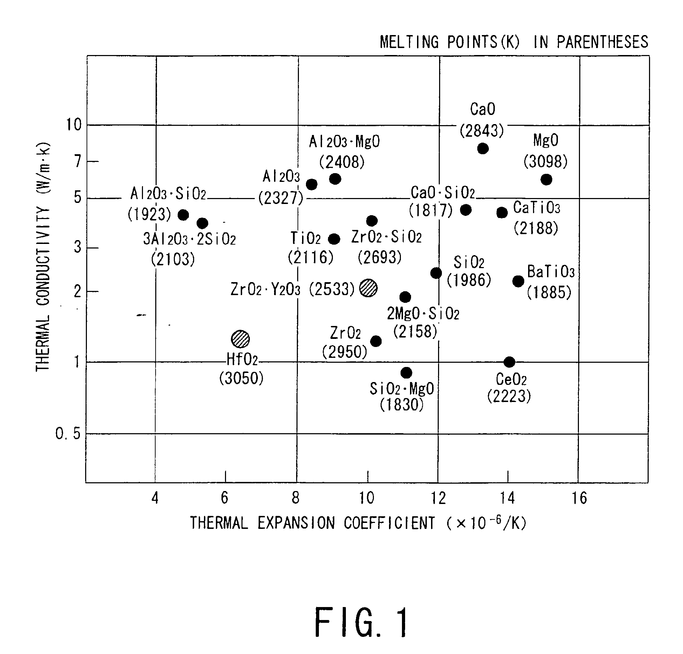

Referring to Fig. 1, which summarizes findings made by the inventors of the present invention, yttrium oxide-stabilized zirconium oxide (melting point: 2,533°C) has a thermal conductivity of about 2 W/m·K, which is a relatively low value among those of various ceramic materials. The thermal conductivity can generally be decreased to about 1.4 W/m·K if a coating layer containing numerous pores is formed by plasma spraying.

It has been confirmed, however, that even for a member (hereinafter referred to as a heat resistant member) having a thermal-barrier coating layer formed of yttrium oxide-stabilized zirconium oxide (ZrO₂·Y₂O₃), the coating layer is sintered and densified and therefore has a decreased number of pores contained therein after extended exposure to a high temperature, namely, not less than 1,200°C. Such densification sintering increases the thermal conductivity of the coating layer, thus degrading its thermal barrier properties. This not only leads to an increase in the temperature of the metal substrate, but also results in accelerated cracking and delamination (peeling-off) of the coating layer and melting of the metal substrate.

### SUMMARY OF THE INVENTION

An object of the present invention, which has been made to solve the above problems, is to provide a heat resistant member with high heat resistance and durability which has a thermal-barrier coating layer with stable thermal conductivity at elevated temperatures, namely, not less than 1,200°C, and resistance to cracking and delamination due to sintering.

To achieve the above object, the present invention provides a heat resistant member including a metal or ceramic substrate and a thermal-barrier coating layer disposed on the substrate. The thermal-barrier coating layer includes a metal layer functioning as a bonding layer and one or more ceramic layers disposed on the metal layer. At least one of the ceramic layers is a hafnium oxide-based ceramic layer containing 85% or more of hafnium oxide.

The substrate used for the heat resistant member is a metal or ceramic substrate with high heat resistance and high strength at elevated temperatures. Preferred examples of the substrate may include metals such as nickel-, cobalt-, or iron-based heat-resistant alloy steels and superalloys and ceramics with high toughness such as sintered silicon nitride (Si₃N₄), sintered zirconia (ZrO₂), sintered silicon carbide (SiC), and sintered carbonaceous materials including C/C composite (carbon fiber-reinforced carbon).

The metal layer functions as a bonding layer to relieve a thermal stress caused by a difference in thermal expansion coefficient between the substrate and the ceramic layers so that they can be firmly bonded. The metal layer is formed by, for example, vapor deposition method or spraying method or the like using an M-chromium-aluminum-yttrium (MCrAlY) alloy (wherein M is at least one element selected from the group consisting of nickel, cobalt, and iron), which has a higher oxidation resistance at elevated temperatures and a higher structural stability than the substrate.

The content of hafnium oxide (HfO₂) in the ceramic layer (purity of hafnium oxide in the ceramic layer) is specified to 85% or more because it significantly affects cracking and delamination, thermal barrier properties, and phase transformation of the hafnium oxide coating. If the hafnium oxide content falls below 85%, promoted sintering causes cracking and delamination of the hafnium oxide coating and degrades its thermal barrier properties (i.e., increases its thermal conductivity) over time. Thus, the hafnium oxide content is specified to 85% or more. The balance, namely, the other components (impurities), is preferably a rare earth oxide, for example, which serves as a stabilizer to prevent phase transformation of hafnium oxide and also as an aid to densify its structure. The balance falls below 15%.

As shown in Fig. 1, the ceramic layer (hafnium oxide layer) of the thermal-barrier coating layer of the above heat-resistant member has a thermal conductivity that is about 30% to 40% lower than that of yttrium oxide-stabilized zirconium oxide (ZrO₂·Y₂O₃), which is a conventionally used material, and also has a melting point that is more than 500°C higher than that of yttrium oxide-stabilized zirconium oxide. The thermal-barrier coating layer can therefore maintain a superior thermal-barrier effect at elevated temperatures over an extended period of time.

Although the use of hafnium oxide with higher purity can inhibit sintering more effectively, it preferably contains a certain amount of an additive element because a large amount of impurities causes the problem of phase transformation. The content of the additive element, however, must be less than 15%, as described above, because the additive element lowers the melting point of the hafnium oxide and therefore promotes its sintering.

In the above heat-resistant member, the hafnium oxide-based ceramic layer preferably has a segmented structure in which the layer is divided into a plurality of hafnium oxide crystal grains formed in a thickness direction of the substrate or in which the layer is randomly divided by cracks running in the thickness direction. That is, the hafnium oxide-based ceramic layer preferably has a segmented structure in which the layer is divided into a plurality of hafnium oxide crystal grains formed in the thickness direction of the substrate or into certain regions.

The ceramic layer having the segmented structure can be formed by the following methods. That is, a sintered powder containing powdered hafnium oxide (HfO₂) as a base component and powdered yttrium oxide (Y₂O₃) as a stabilizer is subjected to physical vapor deposition (PVD) or chemical vapor deposition (CVD) by which heat can be applied to the sintered powder at high energy density to deposit its ceramic component on the surface of the substrate. This method allows formation of a segmented structure in which the ceramic layer is divided into a plurality of columnar hafnium oxide crystal grains formed in the thickness direction of the substrate.

Alternatively, a planar ceramic layer may be formed by plasma spraying method, for example, using granules prepared by granulating powdered hafnium oxide (HfO₂) and powdered yttrium oxide (Y₂O₃), used as a stabilizer, and may then be subjected to, for example, heat treatment to form numerous microcracks running from the surface of the ceramic layer in the thickness direction. This method allows formation of a segmented structure in which the ceramic layer is randomly divided into certain hafnium oxide regions (segments) by the cracks running in the thickness direction.

In the heat resistant member having the ceramic layer thus configured, gaps between the segments can effectively absorb and reduce a stress caused by phase transformation of the hafnium oxide-based ceramic layer and a thermal stress caused by a difference in thermal expansion coefficient between the ceramic layer and the substrate. The above structure can therefore effectively prevent delamination of the thermal-barrier coating layer due to heat cycles. Hence, when used as a component of an apparatus, such as a gas turbine, to be repeatedly subjected to start-and-stop heat cycles, the heat-resistant member can provide high durability and reliability without suffering any damage such as delamination or detachment of the thermal-barrier coating layer occurring.

In the above heat-resistant member, additionally, the hafnium oxide-based ceramic layer preferably contains at least one oxide selected from oxides of rare earth elements including yttrium in an amount of 0% to less than 15%.

The rare earth oxide used in the thermal-barrier coating layer functions as a stabilizer to prevent phase transformation of hafnium oxide, which occurs around 1,400°C. The rare earth oxide can therefore effectively suppress a change in the volume of the ceramic layer due to phase transformation to significantly increase the delamination lifetime of the thermal-barrier coating layer. It is preferred, however, that the content of the rare earth oxide fall below 15%; if the rare earth oxide is contained in a larger amount, namely, not less than 15%, it lowers the melting point of the hafnium oxide and therefore impairs its heat resistance.

In general, the term "rare earth element" refers to 17 elements including lanthanum, cerium, praseodymium, neodymium, promethium, samarium, europium, gadolinium, terbium, dysprosium, holmium, erbium, thulium, ytterbium, ruthenium, scandium, and yttrium. However, in the present invention, the term rare earth element refers to the above elements other than scandium, namely, 16 elements.

In the above heat resistant member, additionally, the hafnium oxide-based ceramic layer is preferably formed by PVD method, CVD method, or plasma spraying method. It is also effective to use any combination of these processes, for example, a combination of plasma spraying method and PVD method or a combination of plasma spraying method and CVD method.

PVD, CVD, or plasma spraying methods can be used to relatively easily form a hafnium oxide layer (ceramic layer) having a segmented structure in which the layer is divided into a plurality of hafnium oxide crystal grains (in the case of PVD method or CVD method) or in which the layer is randomly divided into certain hafnium oxide regions (segments; in the case of plasma spraying method). Use of such a coating structure can significantly increase the delamination lifetime of the coating layer. In particular, electron-beam physical vapor deposition (EB-PVD), which uses an electron beam (EB) as an energy source, is advantageous in terms of coating speed and cost because energy can be supplied to the coating material at high density.

In the above heat resistant member, additionally, the thermal-barrier coating layer preferably includes the metal layer on the substrate, a dense aluminum oxide layer on the metal layer, and the hafnium oxide-based ceramic layer on the aluminum oxide layer.

In the heat resistant member thus configured, the aluminum oxide layer disposed between the metal layer and the hafnium oxide layer (ceramic layer) can suppress formation of new oxide in the interface between the metal layer and the hafnium oxide layer to increase the delamination lifetime of the hafnium oxide layer.

That is, the dense aluminum oxide layer functions as an antioxidant barrier that is superior in oxidation resistance at elevated temperatures, erosion resistance, and adhesion. This aluminum oxide layer can prevent intrusion (invasion) of oxygen into the metal layer to inhibit formation of oxides of the metals (such as cobalt, chromium, or nickel) constituting the metal layer. In addition, the aluminum oxide layer can enhance the adhesion between the metal layer and the ceramic layer to prevent delamination in the vicinity of the interface between the ceramic layer and the metal layer. The aluminum oxide layer can therefore significantly increase the durability of the thermal-barrier coating layer.

In addition, in the above heat resistant member, alternatively, the thermal-barrier coating layer preferably includes the metal layer on the substrate, an aluminum oxide layer on the metal layer, an yttrium oxide layer on the aluminum oxide layer, and the hafnium oxide-based ceramic layer on the yttrium oxide layer.

According to the heat resistant member thus configured, the aluminum oxide layer and the yttrium oxide layer are provided on the metal layer, so that formation of a low-melting-point oxide can be inhibited in the interface between the aluminum oxide layer and the hafnium oxide layer thereby to increase the delamination lifetime of the hafnium oxide layer.

Furthermore, in the above heat resistant member, alternatively, the thermal-barrier coating layer preferably includes the metal layer formed on the surface of the substrate, an aluminum oxide layer formed on the surface of the metal layer, a zirconium oxide layer formed on the surface of the aluminum oxide layer, and the hafnium oxide-based ceramic layer formed on the surface of the zirconium oxide layer.

In the heat resistant member thus configured, formation of a low-melting-point oxide can be inhibited in the interface between the aluminum oxide layer on the metal layer and the hafnium oxide layer thereby to increase the delamination lifetime of the hafnium oxide layer.

In the above heat-resistant member, alternatively, the thermal-barrier coating layer preferably includes the metal layer formed on the surface of the substrate, an aluminum oxide layer formed on the surface of the metal layer, a yttrium oxide layer-formed on the surface of the aluminum oxide layer, a zirconium oxide layer formed on the surface of the yttrium oxide layer, and the hafnium oxide-based ceramic layer formed on the surface of the zirconium oxide layer.

In the heat resistant member thus configured, formation of a low-melting-point oxide can be inhibited in the interfaces between the aluminum oxide layer on the metal layer, the yttrium oxide layer, and the hafnium oxide layer thereby to increase the delamination lifetime of the hafnium oxide layer.

In the above heat resistant member, additionally, at least one of the ceramic layers of the thermal-barrier coating layer is preferably disposed as an intermediate layer in at least one of the interface between the aluminum oxide layer and the yttrium oxide layer, the interface between the yttrium oxide layer and the zirconium oxide layer, and the interface between the zirconium oxide layer and the hafnium oxide-based ceramic layer. The intermediate layer preferably has substantially the same composition as the two adjacent layers in end surfaces of the intermediate layer in a thickness direction thereof, and the composition preferably varies continuously or stepwise in the thickness direction.

That is, the heat-resistant member preferably includes an intermediate layer disposed in at least one of the interfaces between the ceramic layers constituting the thermal-barrier coating layer, including the aluminum oxide layer, the yttrium oxide layer, the zirconium oxide layer, and the hafnium oxide layer, and the composition of the intermediate layer is preferably similar to those of the two adjacent layers in the end surfaces of the intermediate layer in the thickness direction thereof and preferably varies continuously or stepwise in the thickness direction.

In the heat resistant member thus configured, the aluminum oxide layer, the yttrium oxide layer, the zirconium oxide layer, and the intermediate layer are disposed between the hafnium oxide layer and the metal layer, and the composition of the intermediate layer varies continuously or stepwise between the two adjacent layers in the thickness direction. The intermediate layer can relieve a thermal stress caused by a difference in thermal expansion between the two adjacent layers thereby to increase the delamination lifetime of the hafnium oxide layer.

In the above heat resistant member, additionally, the metal layer to be formed on the substrate is preferably a metal coating layer formed of a nickel-cobalt-chromium-aluminum-yttrium alloy (NiCoCrAlY alloy), and the hafnium oxide-based ceramic layer is preferably disposed on the surface of the metal coating layer.

In the heat resistant member thus configured, the use of a nickel-cobalt-chromium-aluminum-yttrium alloy, which is superior in oxidation resistance at elevated temperatures and structural stability, as the material of the metal layer can inhibit growth of an oxide layer on the metal layer and effectively relieve a thermal stress caused by a difference in thermal expansion between the ceramic layer and the substrate thereby to increase the delamination lifetime of the hafnium oxide layer.

In the heat resistant member according to the present invention, the hafnium oxide-based ceramic layer, which has low thermal conductivity and a high melting point, and the metal layer, which is superior in oxidation resistance at elevated temperatures and structural stability, are integrally formed on the substrate as the thermal-barrier coating layer. This thermal-barrier coating layer has stable thermal conductivity at elevated temperatures, namely, not less than 1,200°C, and resistance to cracking and delamination due to sintering and can therefore maintain a superior thermal-barrier effect at elevated temperatures over an extended period of time. In addition, because the hafnium oxide content is 85% or more, it is possible to prevent cracking and delamination due to sintering and to suppress a deterioration in the thermal barrier properties (i.e., an increase in thermal conductivity) of the hafnium oxide coating over time. Furthermore, the addition of a stabilizer element in a concentration of less than 15% can suppress phase transformation and the resulting change in the volume of the ceramic layer thereby to significantly increase the delamination lifetime of the ceramic layer.

### BRIEF DESCRIPTION OF THE DRAWINGS

Fig. 1 is a graph showing the thermal conductivity, thermal expansion coefficient, and melting point of various metal oxides including a ceramic material (HfO₂) used in the present invention;
Fig. 2 is a schematic sectional view of the basic structure of a heat resistant member according to the present invention;
Fig. 3 is a graph showing a difference in temperature distribution between a heat resistant member having a thermal-barrier coating and a heat resistant member having no thermal-barrier coating;
Fig. 4 is a graph showing changes in the thermal conductivity of heat-resistant members with heating temperature in Examples 1 to 3 of the present invention where hafnium oxide layers with different purities were formed;
Fig. 5 is a schematic perspective view of a heat-resistant member according to an example of the present invention, showing a thermal-barrier coating layer including a ceramic layer having a segmented structure;
Figs. 6A to 6D are sectional views of heat resistant members according to other examples of the present invention, showing thermal-barrier coating layers including various oxide layers so as to suppress interfacial reaction;
Fig. 7 is a sectional view of a heat resistant member according to another example of the present invention, showing a thermal-barrier coating layer including an intermediate layer whose composition varies stepwise so as to reduce interfacial thermal stress; and
Fig. 8A is a sectional view of the layer structure of a heat resistant member having a metal layer according to the present invention, and Fig. 8B is a sectional view of the layer structure of a heat-resistant member having no metal layer according to Comparative Example 4.

### DESCRIPTION OF THE PREFERRED EMBODIMENTS

Heat resistant members according to embodiments of the present invention will now be described with reference to the examples below and the attached drawings.

### [Examples 1 to 3 and Comparative Examples 1 and 2]

As schematically shown in Fig. 2, a nickel-based superalloy substrate 1 was coated with a metal layer 2 to a thickness of about 150 µm by vacuum plasma spraying method. The nickel-based superalloy substrate 1 contained, by mass, 16% of chromium (Cr), 8.5% of cobalt (Co), 1.75% of molybdenum (Mo), 2.6% of tungsten (W), 1.75% of tantalum (Ta), 0.9% of niobium (Nb), 3.4% of aluminum (Al), and 3.4% of titanium (Ti), the balance being nickel (Ni). The metal layer 2 was formed of a nickel-cobalt-chromium-aluminum-yttrium alloy containing 32% of nickel, 21% of chromium, 6% of aluminum, and 0.5% of yttrium, the balance being cobalt. The metal layer 2 was then coated with a hafnium oxide layer 3 as a ceramic layer to a thickness of about 300 µm by EB-PVD thereby to form a thermal-barrier coating layer 4. Thus, heat resistant members according to Examples 1 to 3 and Comparative Example 1 were produced, where the ceramic layers were deposited in various mixing ratios of powdered hafnium oxide to powdered yttrium oxide, used as a stabilizer. The mixing ratios were determined so that the contents of hafnium oxide in the raw powders were 98% (Example 1), 90% (Example 2), 85% (Example 3), and 80% (Comparative Example 1).

In addition, a heat resistant member according to Comparative Example 2 was produced by forming a ceramic layer of yttrium oxide-stabilized zirconium oxide (ZrO₂ containing 8% of Y₂O₃) to the same thickness as the ceramic layers of Examples 1 to 3.

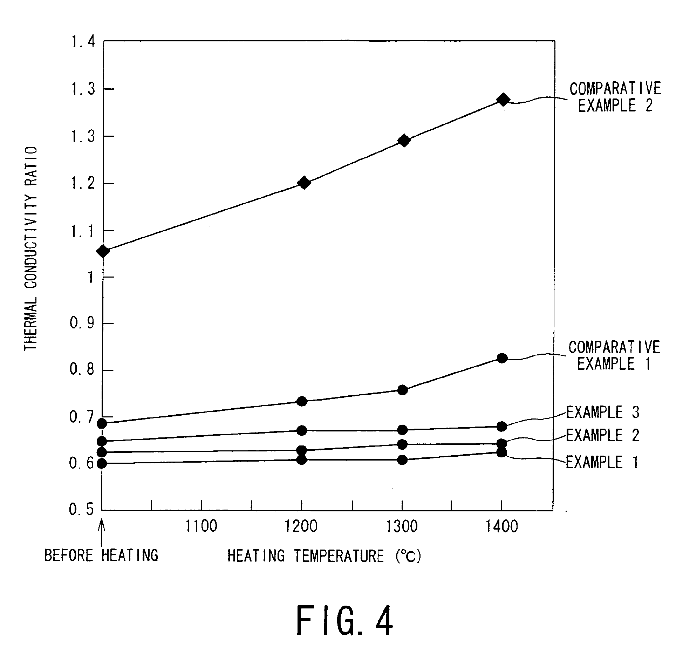

To evaluate the heat resistant members produced in the Examples and the Comparative Examples for thermal stability, test pieces of the heat resistant members were heated in a heating furnace at temperatures of 1,200°C, 1,300°C, and 1,400°C for 100 hours to measure the thermal conductivity of the ceramic layers. The results are shown in Fig. 4.

In Fig. 4, the changes in the thermal conductivity of the hafnium oxide layers before and after the heating test are represented in ratios to the thermal conductivity, defined as 1 (standardized value), of the yttrium oxide-stabilized zirconium oxide layer (Comparative Example 2) before the heating.

As is clear from the results shown in Fig. 4, the hafnium oxide layers of Examples 1 to 3 had a significantly lower thermal conductivity before the heating than the conventional yttrium oxide-stabilized zirconium oxide layer (Comparative Example 2). Thus, the hafnium oxide layers of Examples 1 to 3 had superior thermal barrier properties. In terms of thermal conductivity after the high-temperature heating, the conventional yttrium oxide-stabilized zirconium oxide layer according to Comparative Example 2 tended to have significantly increased thermal conductivity due to sintering while the hafnium oxide layers according to Examples 1 to 3 showed little change in thermal conductivity after the heating. Thus, the hafnium oxide layers of Examples 1 to 3 had high heat resistance. The results also suggest that the content of hafnium oxide must be 85% or more because for the ceramic layer according to Comparative Example 1, containing 80% hafnium oxide, the change in thermal conductivity tended to increase gradually and therefore the thermal barrier properties were degraded.

### [Examples 4 to 6]

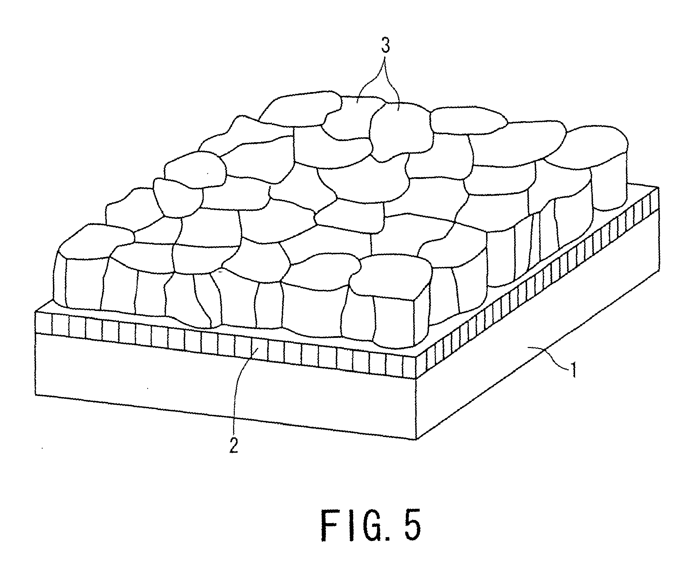

Next, heat resistant members according to other embodiments of the present invention will be described with reference to Figs. 2 and 5 and Table 1. As the same manner as in Examples 1 to 3, the nickel-cobalt-chromium-aluminum-yttrium alloy was sprayed onto the nickel-based superalloy substrate 1 shown in Fig. 2 by using vacuum plasma spraying method thereby to form the metal layer 2 to a thickness of about 150 µm. The metal layer 2 was then coated with the hafnium oxide layer 3, which contained 98% hafnium oxide (balance: Y₂O₃), to a thickness of about 300 µm by plasma spraying method thereby to form the thermal-barrier coating layer 4. Thus, heat resistant materials according to Examples 4 and 5 were prepared.

The heat resistant material according to Example 4 was subjected to a heat treatment in which the material was heated to 900°C and was then quenched so as to form microcracks running in the thickness direction of the hafnium oxide layer 3. Thus, a heat resistant member according to Example 4 was produced, with the hafnium oxide layer 3 having a segmented structure including randomly divided regions, or segments, as shown in Fig. 5. In addition, a test piece of a heat-resistant member according to Example 5 was prepared without the heat treatment; therefore, its hafnium oxide layer 3 had no segmented structure.

As the same manner as in Examples 1 to 3, additionally, the nickel-based superalloy substrate 1 shown in Fig. 2 was coated with the metal layer 2, formed of the nickel-cobalt-chromium-aluminum-yttrium alloy, to a thickness of about 150 µm by vacuum plasma spraying method. The metal layer 2 was then coated with a ceramic layer containing 8% yttrium oxide and 92% hafnium oxide to a thickness of about 300 µm by EB-PVD thereby to form the thermal-barrier coating layer 4. Thus, a heat resistant member according to Example 6 was produced.

These three types of heat resistant members thus produced were evaluated for heat-cycle characteristics and durability by the following heat cycle test. Specifically, the test pieces of the heat resistant members were heated to and held at a temperature of 1,200°C in air for 30 minutes, were cooled to and held at 100°C for 30 minutes, and were reheated to 1,200°C. This heat cycle was repeated for not less than 500 cycles. After the heat cycle test, the hafnium oxide layer 3 was examined and evaluated for damage, and the results are shown in Table 1. In Table 1, the heat resistant members were evaluated as ○ if no damage such as delamination or swelling was found in the ceramic layer (hafnium oxide layer) 3 of the thermal-barrier coating layer 4, were evaluated as Δ if the hafnium oxide layer 3 had a delamination area of 50% or less of the total lamination area or had at least one locally delaminated site, and were evaluated as X, that is, assumed as being completely delaminated, if the hafnium oxide layer 3 had a delamination area of more than 50% of the total lamination area.

**Table 1**

| Heat Cycle Number | 10 cycles | 50 cycles | 100 cycles | 200 cycles | 500 cycles |
|---|---|---|---|---|---|
| Example 4 | ○ | ○ | ○ | Δ | × |
| Example 5 | ○ | Δ | × | × | × |
| Example 6 | ○ | ○ | ○ | ○ | Δ |

| | | | | | |
|---|---|---|---|---|---|
| ○:No Damage, Δ:Partial Delamination or Local Swelling ×: Complete Delamination | | | | | |

As is clear from the results shown in the above Table 1, the hafnium oxide layer 3, having no segmented structure, formed on the heat-resistant member according to Example 5 was locally delaminated after 50 cycles and was completely delaminated after 100 cycles because of the difference in thermal expansion between the hafnium oxide layer 3 and the nickel-based superalloy substrate 1. In contrast, the hafnium oxide layer 3, having the segmented structure, formed on the heat resistant member according to Example 4 was not delaminated even after 150 cycles. This reveals that the segmented structure provides a stress relaxation effect that significantly increases heat-cycle lifetime.

In addition, almost no sign of delamination was found in the test piece of the heat resistant member according to Example 6, coated with the hafnium oxide layer 3 containing 8% yttrium oxide, even after 200 cycles because the yttrium oxide served as a stabilizer to effectively suppress phase transformation of the hafnium oxide layer 3. This reveals that the addition of yttrium oxide for phase stabilization is effective in increasing delamination lifetime. A similar transformation-suppressing effect can also be achieved by adding other rare earth oxides. The content of the rare earth oxide used, such as yttrium oxide, must fall below 15% because increasing the amount of rare earth oxide added tends to gradually decrease the melting point of the hafnium oxide, and therefore also decrease its heat resistance.

### [Examples 7 to 9]

Next, the effect of employing various coating methods to form ceramic layers of heat resistant members according to the present invention will be described with reference to Fig. 2 and Table 2.

The same nickel-cobalt-chromium-aluminum-yttrium alloy (NiCoCrAlY alloy) as used in Examples 1 to 3 was sprayed onto the same nickel-based superalloy substrate 1 as used in Examples 1 to 3, shown in Fig. 2, by vacuum plasma spraying method thereby to form the metal layer 2 to a thickness of about 160 µm. The metal layer 2 was then coated with hafnium oxide containing 8% yttrium oxide as a stabilizer to form the ceramic layer (hafnium oxide layer) 3 to a thickness of about 320 µm, thus forming the thermal-barrier coating layer 4. The coating methods used were plasma spraying method in Example 7, EB-PVD in Example 8, and high-speed gas flame spraying method in Example 9. Thus, heat resistant members according to Examples 7 to 9 were produced.

Test pieces of the heat resistant members produced in Examples 7 to 9 were evaluated for heat-cycle characteristics and durability by the same heat cycle test as performed in Examples 4 to 6 and for abrasion resistance by a blast erosion test. In the blast erosion test, a blast of fine ceramic particles (for example, Al₂O₃ or SiO₂) was applied onto the surface of the ceramic layer 3 at high speed thereby to measure the abrasion loss of the thermal-barrier coating layer 4 per unit time. The results of the heat cycle test and the blast erosion test are shown in Table 2 below.

**Table 2**

| Heat Cycle Number | 50 cycles | 100 cycles | 200 cycles | 500 cycles | Average Abrasion Depth |
|---|---|---|---|---|---|
| Example 7 | ○ | ○ | ○ | Δ | 20 µm |
| Example 8 | ○ | ○ | ○ | ○ | < 10µm |
| Example 9 | Δ | × | × | × | 170µm |

| | | | | | |
|---|---|---|---|---|---|
| ○:No Damage, Δ:Partial Delamination or Local Swelling, ×:Complete Delamination | | | | | |

As is clear from the results shown in Table 2, the heat resistant member according to Example 7, in which the hafnium oxide layer 3 was formed by plasma spraying method, and the heat resistant member according to Example 8, in which the hafnium oxide layer 3 was formed by EB-PVD, had superior heat-cycle characteristics and abrasion resistance. While the heat resistant member according to Example 9, in which the hafnium oxide layer 3 was formed by high-speed gas flame spraying method, was inferior in both properties. One reason is that particles of hafnium oxide (HfO₂), which has an extremely high melting point, namely, 3,050°C, as shown in Fig. 1, are not sufficiently melted by high-speed gas flame spraying method because of its low energy density and will therefore have low binding energy in the coating. Another reason is that the segmented structure shown in Fig. 5 is difficult to be formed by the above method. It has been confirmed that the properties of a hafnium oxide layer formed by CVD are comparable to those of a hafnium oxide layer formed by EB-PVD.

### [Examples 10 to 14 and Comparative Example 3]

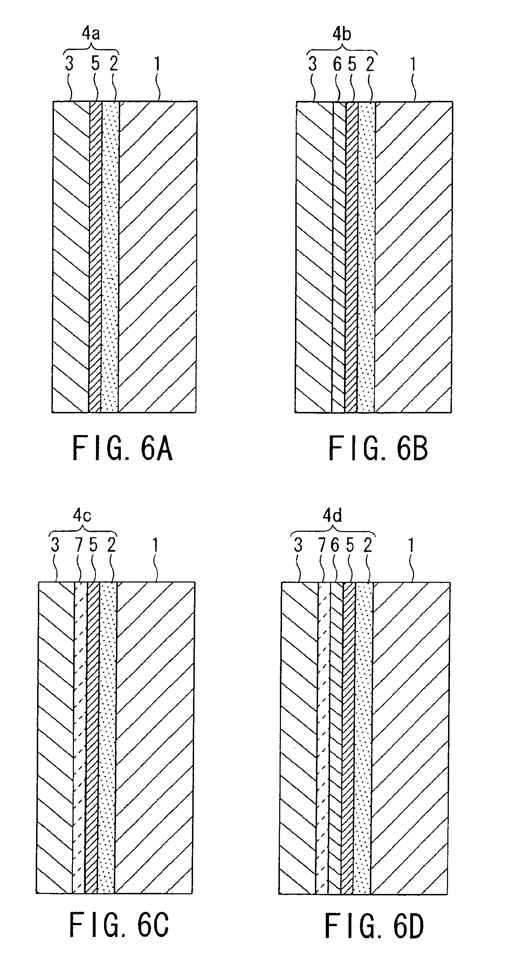

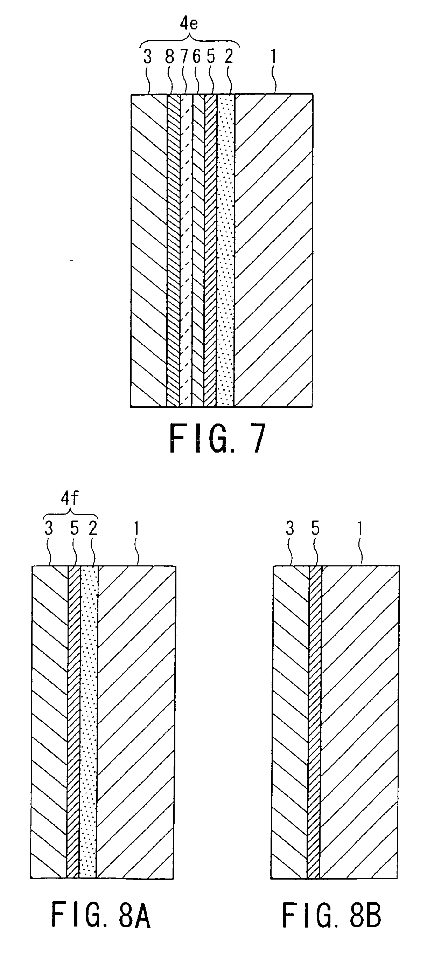

Next, heat resistant members according to other embodiments of the present invention will be specifically described with reference to Figs. 6A to 6D, Fig. 7, and Table 3. As the same manner as in Examples 1 to 3, the nickel-based superalloy substrate 1 was coated with the metal layer 2, formed of the nickel-cobalt-chromium-aluminum-yttrium alloy (NiCoCrAlY alloy), to a thickness of about 150 µm by vacuum plasma spraying method.

Next, at least one of an aluminum oxide layer 5, an yttrium oxide layer 6, and a zirconium oxide layer 7, as described below, was formed by EB-PVD. The outermost layer formed was coated with a ceramic layer containing 92% hafnium oxide (balance: Y₂O₃) to a thickness of about 300 µm by EB-PVD thereby to form thermal-barrier coating layers 4a to 4d. Thus, heat resistant members according to Examples 10 to 13 were produced.

That is, referring to Fig. 6A, the heat resistant member of Example 10 had the thermal-barrier coating layer 4a, in which the aluminum oxide (Al₂O₃ layer 5 was formed on the surface of the metal layer 2 to a thickness of about 1 to 3 µm.

Referring to Fig. 6B, the heat resistant member of Example 11 had the thermal-barrier coating layer 4b, in which the aluminum oxide layer 5 was formed on the surface of the metal layer 2, and the yttrium oxide (Y₂O₃) layer 6 was further formed on the surface of the aluminum oxide layer 5 to a thickness of about 10 to 50 µm.

Referring to Fig. 6C, the heat resistant member of Example 12 had the thermal- barrier coating layer 4c, in which the aluminum oxide layer 5 was formed on the surface of the metal layer 2, and the zirconium oxide (ZrO₂) layer 7 was further formed on the surface of the aluminum oxide layer 5 to a thickness of about 10 to 50 µm.

Referring to Fig. 6D, the heat resistant member of Example 13 had the thermal-barrier coating layer 4d, in which the aluminum oxide layer 5 was formed on the surface of the metal layer 2, and the yttrium oxide layer 6 and the zirconium oxide layer 7 were further sequentially formed on the aluminum oxide layer 5 to a thickness of about 10 to 50 µm for each layer.

Referring to Fig. 7, the nickel-based superalloy substrate 1 used in Example 1 was coated with the metal layer 2, formed of the nickel-cobalt-chromium-aluminum-yttrium alloy (NiCoCrAlY alloy), to a thickness of about 150 µm by vacuum plasma spraying method. The metal layer 2 was then sequentially coated with the aluminum oxide layer 5, the yttrium oxide layer 6, and the zirconium oxide layer 7 to a thickness of 4 µm for each layer. The zirconium oxide layer 7 was coated with the hafnium oxide layer 3, containing 92% hafnium oxide (balance: Y₂O₃), to a thickness of 300 µm with an intermediate layer 8 formed therebetween. That is, the intermediate layer 8 was formed in the interface between the hafnium oxide layer 3 and the zirconium oxide layer 7, where the difference in thermal expansion coefficient was largest. The content of hafnium oxide in the intermediate layer 8 increases in steps of 20% from the zirconium oxide layer 7, namely, 100% zirconium oxide, toward the hafnium oxide layer 3. Thus, a heat resistant member according to Example 14 was produced which had a thermal-barrier coating layer 4e having a six-layer structure.

In order to form the intermediate layer 8, specifically, four types of raw powders were prepared: a raw powder containing 80 mole percent ZrO₂ and 20 mole percent HfO₂; a raw powder containing 60 mole percent ZrO₂ and 40 mole percent HfO₂; a raw powder containing 40 mole percent ZrO₂ and 60 mole percent HfO₂; and a raw powder containing 20 mole percent ZrO₂ and 80 mole percent HfO₂. Using these raw powders, coatings having the respective compositions were formed in layers by EB-PVD.

At the same time, a heat resistant member according to Comparative Example 3 was produced by directly coating the metal layer 2 with the hafnium oxide layer 3, which contained 75% hafnium oxide (balance: Y₂O₃), to a thickness of 300 µm.

Test pieces of the heat-resistant members produced in Examples 10 to 14 and Comparative Example 3 were subjected to a heat cycle test involving not less than 500 heat cycles in which the test pieces were heated at 1,200°C in air for 72 hours, were cooled to 100°C, and were reheated to 1,200°C to examine the delamination properties of the thermal-barrier coating layer 4 after the extended heating. The results are shown in Table 3 below.

**Table 3**

| Heat Cycle Number | 10 cycles | 50 cycles | 100 cycles | 200 cycles | 500 cycles |
|---|---|---|---|---|---|
| Example 10 | ○ | ○ | Δ | × | × |
| Example 11 | ○ | ○ | Δ | Δ | × |
| Example 12 | ○ | ○ | ○ | Δ | × |
| Example 13 | ○ | ○ | ○ | ○ | Δ |
| Example 14 | ○ | ○ | ○ | ○ | ○ |
| Comparative Example 3 | Δ | × | × | × | × |

| | | | | | |
|---|---|---|---|---|---|
| ○:No Damage, Δ: Partial Delamination or Local Swelling, × : Complete Delamination | | | | | |

As is clear from the results of the extended-heating heat cycle test in Table 3, the test piece of the heat resistant member according to Comparative Example 3, in which the metal layer 2 was directly coated with the hafnium oxide layer 3, had a thick oxide layer formed in the interface between the metal layer 2 and the hafnium oxide layer 3 in a short time, and the hafnium oxide layer 3 was delaminated after 50 cycles. This reveals that the heat resistant member had low durability.

On the other hand, for the test piece of the heat resistant member according to Example 10, in which the aluminum oxide layer 5 was formed on the surface of the metal layer 2, as shown in Fig. 6A, an oxide layer grew more slowly in the interface between the metal layer 2 and the hafnium oxide layer 3, and almost no delamination was found after 100 cycles. As the heating time was increased, however, the oxidation reaction proceeded in the interface between the metal layer 2 and the hafnium oxide layer 3, and a delamination tended to appear more prominently.

The test piece of the heat resistant member according to Example 11, in which the yttrium oxide layer 6 was further formed on the surface of the aluminum oxide layer 5, as shown in Fig. 6B, had a longer delamination lifetime than the test piece of the heat resistant member according to Example 10, in which only the aluminum oxide layer 5 was formed on the surface of the metal layer 2. As the heating time was increased, however, a reaction proceeded in the interface between the yttrium oxide layer 6 and the hafnium oxide layer 3, and a delamination tended to appear more prominently.

The test piece of the heat resistant member according to Example 12, in which the zirconium oxide layer 7 was further formed on the surface of the aluminum oxide layer 5, as shown in Fig. 6C, had a still longer delamination lifetime than the test piece of the heat resistant member according to Example 10, in which only the aluminum oxide layer 5 was formed on the surface of the metal layer 2, and the test piece of the heat resistant member according to Example 11, in which the aluminum oxide layer 5 and the yttrium oxide layer 6 were sequentially formed. As the heating time was increased, however, a reaction proceeded in the interface between the aluminum oxide layer 5 and the zirconium oxide layer 7, and a delamination tended-to appear more prominently.

On the other hand, the test piece of the heat resistant member according to Example 13, in which the yttrium oxide layer 6, the zirconium oxide layer 7, and the hafnium oxide layer 3 were sequentially formed on the surface of the aluminum oxide layer 5, as shown in Fig. 6D, was found to have a significantly longer delamination lifetime than the test pieces of Examples 10 to 12.

The heat resistant member according to Example 14, in which the intermediate layer 8 was formed between the hafnium oxide layer 3 and the zirconium oxide layer 7 so as to have stepwise variations in composition, as shown in Fig. 7, had no delamination after 500 cycles. Because the intermediate layer 8, having stepwise variations in composition, was formed in the interface between the different materials, it could effectively reduce thermal stress to significantly increase the delamination lifetime of the thermal-barrier coating layer 4.

### [Example 15 and Comparative Example 4]

Next, heat resistant members according to other embodiments of the present invention will be described with reference to Figs. 8A and 8B and Table 4. Referring to Fig. 8A, the nickel-based superalloy substrate 1 used in Example 1 was coated with the metal layer 2, formed of the nickel-cobalt-chromium-aluminum-yttrium alloy, to a thickness of about 150 µm by vacuum plasma spraying method. The metal layer 2 was then coated with the aluminum oxide layer 5 to a thickness of 1 to 3 µm and with the hafnium oxide layer 3, which contained 95% hafnium oxide (balance: Y₂O₃), to a thickness of 300 µm to form a thermal-barrier coating layer 4f on the substrate 1. Thus, a heat resistant member according to Example 15 was produced.

Referring to Fig. 8B, on the other hand, the nickel-based superalloy substrate 1 was sequentially coated with the aluminum oxide layer 5 and the hafnium oxide layer 3 directly without being coated with the metal layer 2 formed of the nickel-cobalt-chromium-aluminum-yttrium alloy. Thus, a heat-resistant member according to Comparative Example 4 was produced.

Test pieces of the heat resistant members produced in Example 15 and Comparative Example 4 were subjected to a heat cycle test involving not less than 500 heat cycles in which the test pieces were heated at 1,000°C in air for 72 hours, were cooled to 100°C, and were reheated to 1,000°C to examine the delamination properties of the thermal-barrier coating layer 4 after extended heating. The results are shown in Table 4 below.

**Table 4**

| Heat Cycle Number | 10 cycles | 50 cycles | 100 cycles | 200 cycles | 500 cycles |
|---|---|---|---|---|---|
| Example 15 | ○ | ○ | Δ | × | × |
| Comparative Example 4 | Δ | × | × | × | × |

| | | | | | |
|---|---|---|---|---|---|
| ○: No Damage, Δ:Partial Delamination or Local Swelling, × : Complete Delamination | | | | | |

According to the results of the extended-heating heat cycle test in Table 4, the test piece of the heat resistant member according to Comparative Example 4, in which the nickel-based superalloy substrate 1 was directly coated with the aluminum oxide layer 5 and the hafnium oxide layer 3, as shown in Fig. 8B, had a thick oxide layer formed in the interface between the nickel-based superalloy substrate 1 and the hafnium oxide layer 3 in a short time, and the hafnium oxide layer 3 was delaminated in a short time, namely, after 50 cycles. This reveals that the heat resistant member of Comparative Example 4 had insufficient durability.

In contrast, for the test piece of the heat resistant member according to Example 15, in which the nickel-based superalloy substrate 1 was coated with the metal layer 2 formed of the nickel-cobalt-chromium-aluminum-yttrium alloy, as shown in Fig. 8A, an oxide layer grew more slowly in the interface between the metal layer 2 and the hafnium oxide layer 3, and almost no delamination was found after 100 cycles. As the heating time was increased, however, the reaction proceeded in the interface between the aluminum oxide layer 5 and the hafnium oxide layer 3, and a delamination tended to appear more prominently.
It is explicitly stated that all features disclosed in the description and/or the claims are intended to be disclosed separately and independently from each other for the purpose of original disclosure as well as for the purpose of restricting the claimed invention independent of the compositions of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A heat resistant member comprising:
a metal or ceramic substrate; and
a thermal-barrier coating layer disposed on the substrate, the thermal-barrier coating layer including a metal layer functioning as a bonding layer and one or more ceramic layers disposed on the metal layer, wherein at least one of the ceramic layers is a hafnium oxide-based ceramic layer containing 85% or more of hafnium oxide.

2. The heat resistant member according to Claim 1, wherein the hafnium oxide-based ceramic layer has a segmented structure in which the layer is divided into a plurality of hafnium oxide crystal grains formed in a thickness direction of the substrate or in which the layer is randomly divided by cracks running in the thickness direction.

3. The heat resistant member according to Claim 1 or 2, wherein the hafnium oxide-based ceramic layer contains at least one oxide selected from oxides of rare earth elements including yttrium in an amount of 0% to less than 15%.

4. The heat resistant member according to any one of Claims 1 to 3, wherein the hafnium oxide-based ceramic layer is formed by physical vapor deposition, chemical vapor deposition, plasma spraying, or any combination thereof.

5. The heat resistant member according to any one of Claims 1 to 4, wherein the thermal-barrier coating layer includes the metal layer, an aluminum oxide layer formed on the metal layer, and the hafnium oxide-based ceramic layer formed on the aluminum oxide layer.

6. The heat resistant member according to any one of Claims 1 to 4, wherein the thermal-barrier coating layer includes the metal layer, an aluminum oxide layer formed on the metal layer, a yttrium oxide layer formed on the aluminum oxide layer, and the hafnium oxide-based ceramic layer formed on the yttrium oxide layer.

7. The heat-resistant member according to any one of Claims 1 to 4, wherein the thermal-barrier coating layer includes the metal layer, an aluminum oxide layer formed on the metal layer, a zirconium oxide layer formed on the aluminum oxide layer, and the hafnium oxide-based ceramic layer formed on the zirconium oxide layer.

8. The heat resistant member according to any one of Claims 1 to 4, wherein the thermal-barrier coating layer includes the metal layer, an aluminum oxide layer formed on the metal layer, a yttrium oxide layer formed on the aluminum oxide layer, a zirconium oxide layer formed on the yttrium oxide layer, and the hafnium oxide-based ceramic layer formed on the zirconium oxide layer.

9. The heat resistant member according to any one of Claims 5 to 8, wherein at least one of the ceramic layers of the thermal-barrier coating layer is an intermediate layer disposed in at least one of an interface between the aluminum oxide layer and the yttrium oxide layer, an interface between the yttrium oxide layer and the zirconium oxide layer, and an interface between the zirconium oxide layer and the hafnium oxide-based ceramic layer, the intermediate layer having substantially the same composition as the two adjacent layers in end surfaces of the intermediate layer in a thickness direction thereof, the composition varying continuously or stepwise in the thickness direction.

10. The heat resistant member according to any one of Claims 1 to 9, wherein the metal layer functioning as a bonding layer is formed of an M-chromium-aluminum-yttrium alloy (wherein M is at least one element selected from the group consisting of nickel, cobalt, and iron), and the hafnium oxide-based ceramic layer being disposed on the metal layer.
